# EUROPÄISCHE PATENTANMELDUNG

(11) **EP 2 698 833 A1**
(43) Veröffentlichungstag der Anmeldung: **19.02.2014**
(21) Anmeldenummer: 13179899.3
(22) Anmeldetag: 09.08.2013
(51) Int. Cl.: H01L 35/30, H01L 35/32

(54) **Thermoelektrischer Wärmetauscher**

(30) Priorität: 17.08.2012 DE 102012214700
(71) Anmelder: Behr GmbH & Co. KG, 70469 Stuttgart (DE)
(72) Erfinder: Himmer, Dipl.-Ing. (FH) Thomas, 73326 Reichenbach (Deggingen) (DE)
(74) Vertreter: Grauel, Andreas

(57) **Zusammenfassung**

Die Erfindung betrifft einen thermoelektrischen Wärmetauscher, umfassend zwei Rohre (2, 3), wobei ein erstes Rohr (2) ein zweites Rohr (3) umschließt.

Bei einem thermoelektrischen Wärmetauscher, welcher einen hohen Wirkungsgrad aufweist, ist eine thermoelektrische Materialeinheit (8), vorzugsweise mechanisch kontaktfrei zum ersten und zweiten Rohr (2, 3), zwischen dem ersten und dem zweiten Rohr (2, 3) angeordnet und ein erstes Fluid (10) umströmt das erste Rohr (2) von außen, während ein zweites Fluid (11) durch das zweite Rohr (3) strömt.

## Beschreibung

### Technisches Gebiet

Die Erfindung betrifft einen thermoelektrischen Wärmetauscher nach dem Oberbegriff von Anspruch 1.

### Stand der Technik

Die im Abgas in Form von Wärme gespeicherte Energie eines Kraftfahrzeuges wird ungenutzt an die Umgebung abgeführt. Um den Wirkungsgrad des Fahrzeuges zu erhöhen und somit den CO₂-Ausstoß während des Betriebes des Kraftfahrzeuges zu senken, ist angedacht, in Kraftfahrzeugen einen thermoelektrischen Generator zu implementieren. Dieser thermoelektrische Generator wandelt einen Teil der im Abgas enthaltenen Wärme in elektrische Energie um, wobei diese elektrische Energie dem Kraftfahrzeug zugeführt wird. Der thermoelektrische Generator kann mit unterschiedlichem Nutzen an beliebiger Stelle im Abgasstrang oder in der Abgasrückführung angeordnet werden. An sich bekannte thermoelektrische Materialien, die heute eingesetzt werden, sind aufgrund ihrer Gestaltung und Verbindungstechnik jedoch nicht optimal für den Einsatz in einem thermoelektrischen Generator geeignet und in ihrem Wirkungsgrad auch wenig effektiv.

### Darstellung der Erfindung, Aufgabe, Lösung, Vorteile

Es ist die Aufgabe der Erfindung, einen thermoelektrischen Wärmetauscher zu schaffen, der einen hohen Wirkungsgrad aufweist und konstruktiv einfach in einem thermoelektrischen Generator einsetzbar ist.

Dies wird erreicht mit den Merkmalen von Anspruch 1, durch einen thermoelektrischen Wärmetauscher, umfassend zwei Rohre, wobei ein erstes Rohr ein zweites Rohr umschließt, und eine thermoelektrische Materialeinheit, die zwischen dem ersten und dem zweiten Rohr angeordnet ist, wobei ein erstes Fluid das erste Rohr von außen umströmt, während ein zweites Fluid durch das zweite Rohr strömt, und wobei die thermoelektrische Materialeinheit an einem Leiterprofil befestigt ist, welches das erste und das zweite Rohr über die thermoelektrische Materialeinheit mechanisch miteinander verbindet.

Dies hat den Vorteil, dass eine thermoelektrische Materialeinheit einfach in den Wärmetauscher eingebunden werden kann. Darüber hinaus besteht eine hohe Effizienz aufgrund eines geringeren Wärmedurchgangswiderstandes zwischen den thermoelektrisch aktiven Materialien und Wärmequellen/- senken. Dadurch entsteht ein konstruktiv einfacher thermoelektrischer Wärmetauscher, welcher ohne großen Aufwand in einem thermoelektrischen Generator einsetzbar ist. Ein solcher Wärmetauscher produziert einen elektrischen Strom, in dem Wärme in elektrische Energie umgewandelt wird. Die Wärme wird dabei durch die beiden Fluids auf die thermoelektrische Materialeinheit übertragen. Solche thermoelektrischen Wärmetauscher können aber auch in thermoelektrischen Heizern oder Kühlern verbaut werden, wo sie im Unterschied zu einem thermoelektrischen Generator bestromt werden, die elektrische Energie in Wärme umwandeln und dadurch Wärme von einem Medium in das andere fördern.

Vorteilhafterweise ist die thermoelektrische Materialeinheit an einem Leiterprofil befestigt, welches das erste und das zweite Rohr mechanisch miteinander verbindet. Durch diese Anbindung der thermoelektrischen Materialeinheit werden die thermischen Widerstände zwischen dem Fluid und der thermoelektrischen Materialeinheit minimiert. Darüber hinaus ist ein solcher thermoelektrischer Wärmetauscher in der Lage, über das Leiterprofil, welches vorzugsweise brückenähnlich ausgebildet ist, thermomechanische Spannungen aufzunehmen und Wärmeverluste zu reduzieren. Eine Thermoelektrik kann auf geeignete Weise in einen solchen Wärmetauscher integriert werden.

In einer Ausgestaltung ist das Leiterprofil zweiteilig ausgebildet, wobei ein erster Teil des Leiterprofils am zweiten Rohr positioniert ist, während ein zweiter Teil des Leiterprofils an dem ersten Rohr befestigt ist und der erste und der zweite Teil des Leiterprofils über die thermoelektrische Materialeinheit miteinander verbunden sind. Durch diese schwebende Anordnung der thermoelektrischen Materialeinheit wird einerseits eine zuverlässige elektrische Verbindung realisiert, zum anderen werden durch die Positionierung der thermoelektrischen Materialeinheit ausschließlich an dem Leiterprofil thermomechanische Spannungen ausgeglichen.

In einer Variante besteht das Leiterprofil aus einer Mehrzahl von, in einen Spalt zwischen dem ersten und dem zweiten Rohr eingreifende Elemente, wobei die freien Enden der ersten Elemente des ersten Teiles des Leiterprofils und die freien Enden der zweiten Elemente des zweiten Teiles des Leiterprofils zueinander so ausgerichtet sind, dass wenigstens zwei, zueinander ragende, vorzugsweise L- oder T-ähnlich ausgebildete Elemente des ersten Teiles und des zweiten Teiles des Leiterprofils die thermoelektrische Materialeinheit tragen. Durch das Ineinandergreifen des ersten Elementes des ersten Teiles und des zweiten Elementes des zweiten Teiles des Leiterprofils und das gleichzeitige Tragen der thermoelektrischen Materialeinheit ist eine sehr kompakte Ausbildung des thermoelektrischen Wärmetauschers möglich, welche platzsparend beispielsweise in einen thermoelektrischen Generator eingebaut werden kann.

In einer Weiterbildung ist der Spalt zwischen dem ersten und dem zweiten Rohr mit einem Füllmaterial ausgefüllt. Die wärmedämmenden Eigenschaften des Füllmaterials erlauben eine gute wärmetechnische Isolierung des thermoelektrischen Wärmetauschers gegenüber der Umgebung sowie des ersten und des zweiten Rohres zueinander.

In einer Ausführungsform weisen die ersten und/oder zweiten Elemente des Leiterprofils mindestens eine Dehnfuge auf. Die Dehnfuge hat den Vorteil, dass thermoelektrische Spannungen durch diese Dehnfugen ausgeglichen werden.

Vorteilhafterweise weisen die, den ersten und/oder den zweiten Teil des Leiterprofils tragenden Flächen des ersten und/oder des zweiten Rohres eine elektrische Isolation auf, wobei vorzugsweise zwischen der elektrischen Isolation und jedem der ersten und/oder zweiten Elemente des Leiterprofils eine erste Verbindungsschicht aufgetragen ist. Da diese erste Verbindungsschicht elektrisch leitend ausgebildet ist, kann elektrische Energie in Form eines Stromes aus dem thermoelektrischen Wärmetauscher aus- oder in diesen eingeleitet werden. Die elektrische Isolation dient zur Vermeidung von Kurzschlüssen und elektrischen Überbrückungen, so dass die Rohre auch aus metallischem Material hergestellt werden können.

In einer Variante ist auf der thermoelektrischen Materialeinheit eine Barriereschicht aufgetragen, wobei vorzugsweise die Barriereschicht und jedes Element des ersten und/oder zweiten Teiles des Leiterprofils über eine zweite Verbindungsschicht miteinander verbunden sind. Die Barriereschichten unterbinden dabei das Ausdififundieren von chemischen Elementen aus den thermoelektrischen Materialeinheiten.

In einer Ausgestaltung weist das erste und/oder das zweite Rohr mindestens einen elektrischen Anschluss auf, welcher mit der elektrisch leitenden ersten Verbindungsschicht der, den ersten und/oder den zweiten Teil des Leiterprofils tragenden Flächen des zweiten und des ersten Rohres kontaktiert ist. Diese elektrischen Anschlüsse können sowohl am ersten als auch am zweiten Rohr vorgesehen sein, welche dazu über entsprechende Öffnungen verfügen, so dass diese über elektrische Leitungen mit der thermoelektrischen Materialeinheit kommunizieren können.

Alternativ sind elektrische Leiterstränge vorhanden, welche mit den thermoelektrischen Materialeinheiten über die elektrisch leitende erste Verbindungsschicht, das Leiterprofil sowie die elektrisch leitende zweite Verbindungsschicht verbunden sind und an die elektrischen Anschlüsse des ersten bzw. des zweiten Rohres führen.

Eine andere Ausführungsform zeigt, dass das erste und das zweite Rohr in mindestens einem vorgegebenen Abstand durch ein, vorzugsweise thermoelastisches, Entkopplungselement unterbrochen sind. Das Entkopplungselement hat die Aufgabe, thermische Ausdehnungsunterschiede zwischen einer kalten und einer heißen Seite des Wärmetauschers auszugleichen bzw. auftretende Spannungen aufzunehmen. Das hat die Wirkung, dass sich das erste und das zweite Rohr oder Rohrsektionen von diesen in ihrer Lage einander anpassen können, wodurch verhindert wird, dass in den thermomechanisch sensiblen Bereichen der thermoelektrischen Schichten, wie thermoelektrisches Material, Isolationsschicht, Leiterprofil oder Verbindungsleitung, Verspannungen auftreten.

Ferner sind die Entkopplungselemente den Rohren vor- und/oder nachgeschaltet. Die Entkopplungselemente können dabei als Federn oder als Balge ausgebildet sein.

Weitere vorteilhafte Ausgestaltungen sind durch die nachfolgende Figurenbeschreibung und durch die Unteransprüche beschrieben.

### Kurze Beschreibung der Zeichnungen

Nachstehend wird die Erfindung auf der Grundlage zumindest eines Ausführungsbeispiels anhand der Zeichnungen näher erläutert. Es zeigen:
- Fig. 1: eine schematische Darstellung eines Ausschnittes aus einem ersten Ausführungsbeispiel eines erfindungsgemäßen thermoelektrischen Wärmetauschers,
- Fig.2: einen ersten Schritt zum Zusammenbau des thermoelektrischen Wärmetauschers nach Fig. 1,
- Fig. 3: einen zweiten Schritt des Zusammenbaus des thermoelektrischen Wärmetauschers nach Fig. 1,
- Fig. 4: einen dritten Schritt des Zusammenbaus des thermoelektrischen Wärmetauschers nach Fig. 1,
- Fig. 5: einen vierten Schritt des Zusammenbaus des thermoelektrischen Wärmetauschers nach Fig. 1,
- Fig. 6: einen fünften Schritt des Zusammenbaus des thermoelektrischen Wärmetauschers nach Fig. 1,
- Fig. 7: einen sechsten Schritt des Zusammenbaus des thermoelektrischen Wärmetauschers nach Fig. 1,
- Fig. 8: einen Schnitt durch einen montierten thermoelektrischen Wärmetauscher nach Fig. 1,
- Fig. 9: ein zweites Ausführungsbeispiel des erfindungsgemäßen Wärmetauschers,
- Fig. 10: ein erstes Ausführungsbeispiel für eine thermoelektrische Vorrichtung mit einem elektrischen Ersatzschaltbild,
- Fig. 11: ein zweites Ausführungsbeispiel einer thermoelektrischen Vorrichtung mit einem Ersatzschaltbild,
- Fig. 12: ein drittes Ausführungsbeispiel einer thermoelektrischen Vorrichtung mit elektrischem Ersatzschaltbild.

### Bevorzugte Ausführung der Erfindung

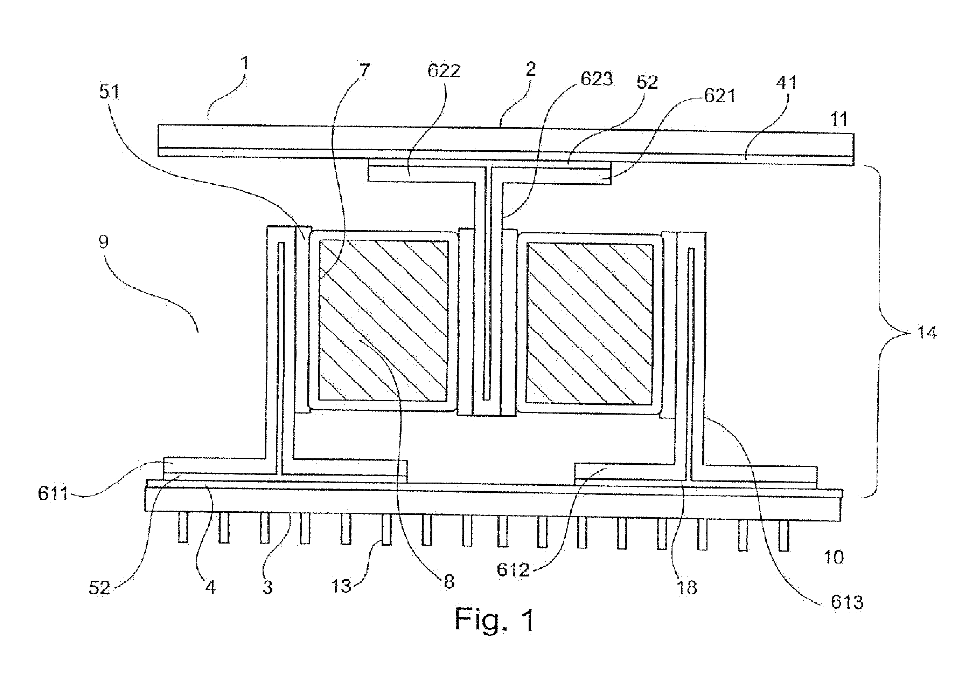

Die Figur 1 zeigt ein erstes Ausführungsbeispiel eines erfindungsgemäßen thermoelektrischen Wärmetauschers 1, welcher als Doppelrohr ausgebildet ist. Das Doppelrohr umfasst dabei zwei, jeweils einen rechteckigen Querschnitt aufweisende Rohre 2, 3, die auch als Flachrohre bezeichnet werden, wobei das erste Rohr 2 das zweite Rohr 3 vollständig umfasst. Zwischen dem außen liegenden ersten Rohr 2 und dem innen liegenden zweiten Rohr 3 besteht ein Rohrspalt 14, welcher mit einer oder mehreren thermoelektrischen Vorrichtungen 20 ausgefüllt ist. Diese thermoelektrische Vorrichtung 20 umfasst eine thermoelektrische Materialeinheit 8, die aufgrund eines speziell ausgeformten Leiterprofils 6 in Kombination mit Dehnfugen 18 nicht unmittelbar mit den Rohren 2, 3 kontaktiert ist.

Die Rohre 2, 3 sind aus zwei Halbrohren 21, 22; 31, 32 gefertigt, welche an den Berührungsstellen miteinander verbunden, vorzugsweise verlötet, sind. Innerhalb des inneren zweiten Rohres 3 wird ein erstes Fluid 10 geführt, während das erste Rohr 2 außen von einem zweiten Fluid 11 umflassen wird. Das zweite Rohr 3 weist dabei in sein Inneres weisende Rippen 13 auf, um die Oberfläche des zweiten Rohres 3 für den Wärmeaustausch mit dem Fluid 10 zu vergrößern.

Die Rohre 2, 3 können aus unterschiedlichen Materialien hergestellt sein. So kann zum Beispiel Keramik in Form von Aluminiumoxid, Aluminiumnitrit, Siliziumnitrit oder Magnesiumoxid verwendet werden. Genauso ist der Einsatz eines Metalls, wie ferritischer und austenitischer Edelstahl, Nickel, einer Nickelbasislegierung, einer Eisen-Nickel-Legierung (Invar), einer Eisen-Nickel-Kobalt-Legierung (Kovar), Titan, einer Titanlegierung, Molybdän, Tantal, Chrom oder Wolfram möglich.

Zur Vermeidung von Kurzschlüssen oder elektrischen Überbrückungen sind die metallischen Rohre 2, 3 auf den zueinandergerichteten Flächen mit je einer elektrischen Isolation versehen, welche als keramische oder glasartige Beschichtung ausgebildet ist. Dabei trägt das erste Rohr 2 die elektrische Isolierung 41 innen, während die elektrische Isolierung 42 außen auf dem zweiten Rohr 3 aufgebracht ist. Zum Zwecke der äußerlichen sowie inneren Anbindung der Rohre 2, 3 an beispielsweise das Leiterprofil 6 oder die Rippen 13 können diese Rohre 2, 3 entsprechend metallisiert oder beschichtet sein.

Die thermoelektrische Materialeinheit 8 ist vollständig von einer Barriereschicht 7 umgeben, welche beispielsweise auf einer Basis von Ni, Co, Cr, Ti, Wo oder Ta ausgebildet ist. Das Aufbringen kann auf unterschiedliche Weise erfolgen und galvanisch, stromlos, durch thermische Beschichtung, durch Sputterung, Heißpressen oder Drucksintern erfolgen.

Das Leiterprofil 6 ist zweiteilig ausgebildet und weist zwei Teile 61, 62 auf. Dabei ragen die beiden Teile 61, 62 des Leiterprofils 6 mit den freien Enden der ersten Elemente 611 des ersten Teiles 61 und den freien Enden der zweiten Elemente 621 des zweiten Teiles 62 in einander, wobei zwischen den freien Enden je eines ersten Elementes 611 des ersten Teils 61 des Leiterprofils 6 und je eines zweiten Elementes 621 des zweiten Teils 62 des Leiterprofils 6 die thermoelektrische Materialeinheit 8 befestigt ist und von dem ersten Element 611 und dem zweiten Element 621 getragen wird. Die Elemente 611, 621 sind annähernd T-ähnlich ausgebildet. Die Barriereschicht 7 der thermoelektrischen Materialeinheit 8 ist dabei über eine erste Verbindungsschicht 51 mit dem jeweiligen freien Ende eines ersten Elementes 611 des ersten Teiles 61 des Leiterprofils 6 und des freien Endes eines zweiten Elementes 621 des zweiten Teiles 62 des Leiterprofils 6 fest verbunden.

Insbesondere, wenn die Elemente 611, 621 des ersten und des zweiten Teiles 61, 62 des Leiterprofils 6 T-ähnlich ausgebildet sind, ist innerhalb des langen Schenkels 613, 623, welcher das freie Ende des jeweiligen Elementes 611, 621 bildet, eine Dehnfuge 18 ausgebildet. Die kurzen Schenkel 612, 622 des jeweiligen T-ähnlichen Elementes 611, 621 sind parallel entweder an der Innenseite des ersten Rohres 2 oder an der Außenseite des zweiten Rohres 3 befestigt. Dabei ist auf die elektrische Isolierung 41, 42 des jeweiligen Rohres 2, 3 eine zweite Verbindungsschicht 52 aufgebracht, an welcher die kurzen Schenkel 612, 622 der T-ähnlichen Elemente 611, 621 anliegen und mit diesen fest verbunden sind. Aufgrund dieser Anordnung ist die thermoelektrische Materialeinheit 8 so in dem Rohrspalt 14 zwischen den Rohren 2 und 3 befestigt, dass die thermoelektrische Materialeinheit 8 die Rohre 2, 3 nicht berührt.

Der Rohrspalt 14 zwischen den Rohren 2, 3 ist mit einem wärmedämmenden Füllmaterial 9 ausgefüllt, welches beispielsweise ein Gas wie Stickstoff oder Argon, aber auch ein Festkörper wie Keramikmatten, Mineralwolle, Schaum, Glas, Siliziumoxid oder Kunststoff sein kann. Genauso können aber als Füllmaterialien 9 auch ein Gel oder Pasten verwendet werden.

Die Verbindungsschichten 51, 52 können dabei mit unterschiedlichen Materialien und Verbindungstechniken hergestellt werden, die teilweise elektrisch leitende und teilweise elektrisch nicht leitende Eigenschaften besitzen. So kann die Verbindungsschicht 51, 52 aus einem organischen Kleber wie einem Silikonkleber oder einem Epoxidharzkleber bestehen. Alternativ kann ein organischer Kleber aus einem Metall- oder Keramikpulver mit chemisch vernetzenden oder aushärtenden Bindern vorgenommen werden. Vorstellbar ist auch ein Laserstrahlschweißen oder ein Plasma-WIG-Schweißen. Löten und verwandte Verfahren wie Active Metal Brazing, Breitspaltaktivlöten, Reactive Air Brazing, Gaslöten, Diffusions-Brazing, Hot Pressing, Sinter Pressing, Direct Copper Bonding sind auch vorstellbar. Dazu werden Lote, Lotpasten, Lotfolien und Verbindungsmaterialien wie SnAg-, ZnAl-, CuAl-, CuAg-, CuP-, CuZn-, CuNi-, Ag-, AgCu-, Au- oder Ni-basierte Materialien verwendet, die Schmelzpunkte je nach Zusammensetzung zwischen 600°C und 1200°C aufweisen. Zum Zwecke der Anbindung kann es erforderlich sein, dass die Verbindungsflächen der Fügepartner im Vorfeld gereinigt, aktiviert, metallisiert oder beschichtet werden müssen. In einer weiteren Variante sind auch flüssig-metallische Materialien wie Ga-, In-, Zn-oder Bi-basierte Materialien zur thermischen und/oder thermischen und elektrischen Kontaktierung einsetzbar.

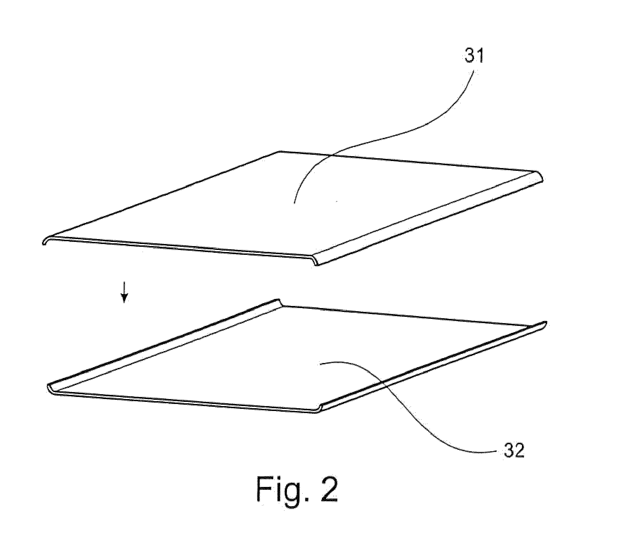

In den nachfolgenden Figuren 2 - 7 ist die Herstellung des thermoelektrischen Wärmetauschers 1 gemäß Fig. 1 näher erläutert. Gemäß Fig. 2 wird das zweite Rohr 3 aus zwei Halbschalen 31 und 32 zusammengesetzt und an den Verbindungsflächen gefügt. An das als Flachrohr ausgebildete zweite Rohr 3 wird auf jeder Seite jeweils ein Leiterprofil 6 aufgesetzt, wobei das Leiterprofil 6 aus zwei Teilen 61, 62 besteht, die ineinander greifen. Jedes Teil 61, 62 des Leiterprofils 6 besteht aus einer Vielzahl einzelner Elemente 611, 621.

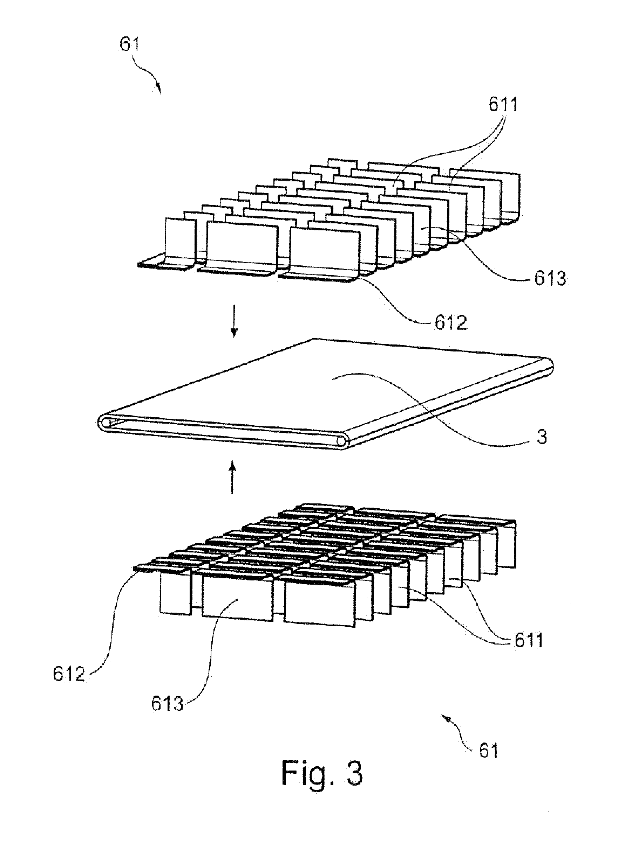

Die in Fig. 3 dargestellten Elemente 611 des ersten Teiles 61 des Leiterprofils 6 sind dabei der Übersichtlichkeit halber L-förmig gestaltet, wobei die Elemente 611 in mehreren Reihen hinter- und nebeneinander gitterähnlich angeordnet sind. Die Elemente 611 des ersten Teiles 61 des Leiterprofils 6 weisen dabei kurze Schenkel 612 auf, welche parallel zur Oberfläche des zweiten Rohres 3 ausgerichtet sind. Die langen Schenkel 613 sind annähernd senkrecht zur Oberfläche des zweiten Rohres 3 ausgerichtet.

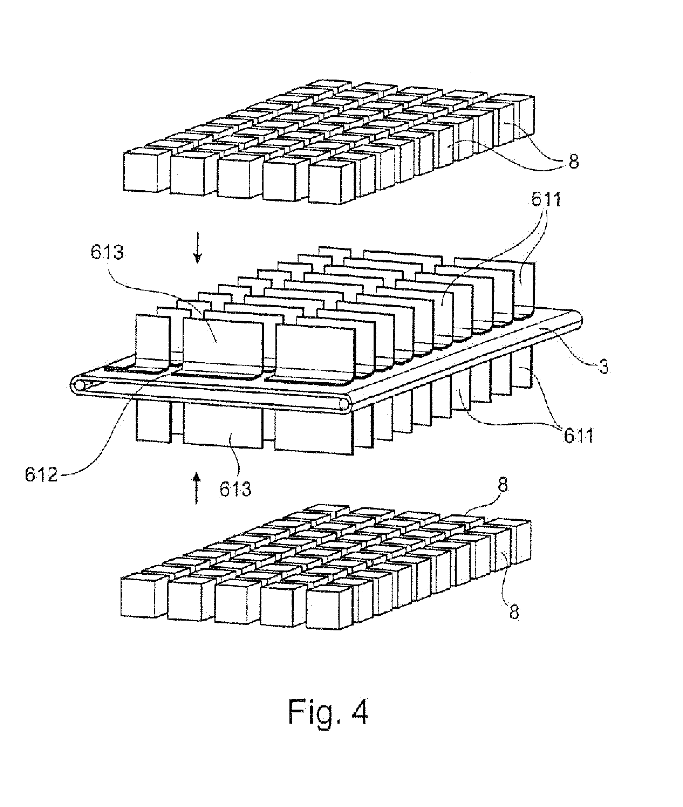

Nach dem beidseitigen Aufsetzen der kurzen Schenkel 612 des ersten Teiles 61 des Leiterprofils 6 auf das zweite Rohr 3, wie es in Fig. 3 dargestellt ist, werden gemäß Fig. 4 die quaderförmig ausgebildeten thermoelektrischen Materialeinheiten 8 jeweils in die Zwischenräume zwischen den langen Schenkeln 613 der ersten Elemente 611 des ersten Teiles 61 des Leiterprofils 6 eingeführt. Diese thermoelektrischen Materialeinheiten 8 werden auf die, in Zusammenhang mit Fig. 1 beschriebene Art und Weise an den langen Schenkeln 613 der einzelnen ersten Elemente 611 des ersten Teiles 61 des Leiterprofils 6 befestigt, so dass kein direkter Kontakt der thermoelektrischen Materialeinheit 8 zum zweiten Rohr 3 besteht.

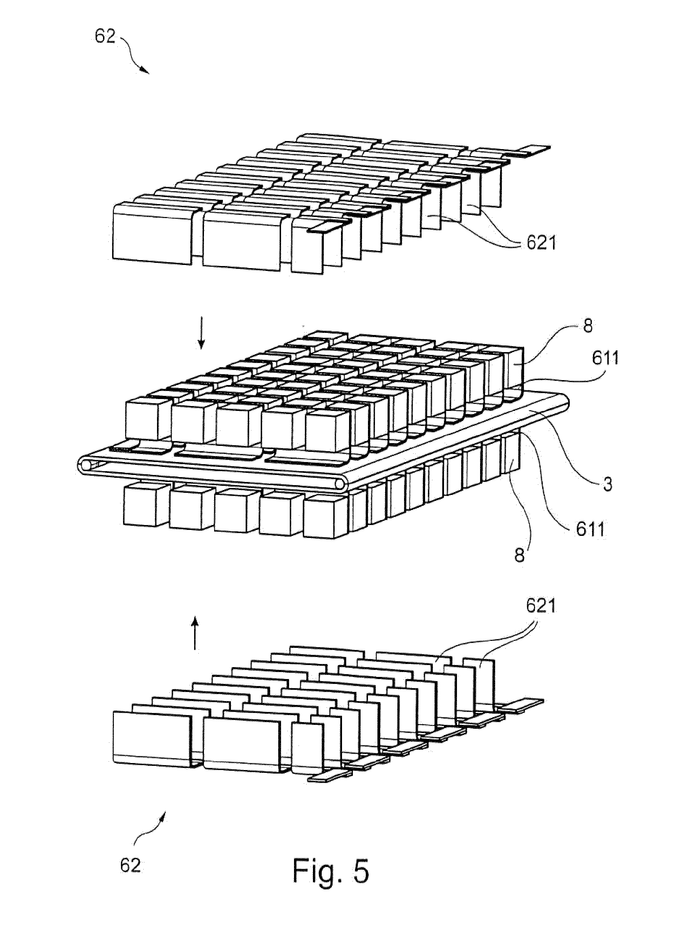

Gemäß Fig. 5 wird anschließend der zweite Teil 62 des Leiterprofils 6 über den ersten Teil 61 des Leiterprofils 6 positioniert, welches die thermoelektrischen Materialeinheiten 8 trägt. Die zweiten Elemente 621 des zweiten Teiles 62 des Leiterprofils 6 sind analog zu den ersten Elementen 611 des ersten Teiles 61 des Leiterprofils 6 ausgebildet, wobei jedes zweite Element 621 ebenfalls einen kurzen Schenkel 622 und einen langen Schenkel 623 aufweist. Dabei sind die kurzen Schenkel 622 der zweiten Elemente 621 des zweiten Teiles 62 des Leiterprofils 6 parallel zum ersten Rohr 2 angeordnet und an diesen befestigt, während der lange Schenkel 623 jeweils eines zweiten Elementes 621 des zweiten Teiles 62 des Leiterprofils 6 einen freien Bereich der thermoelektrischen Materialeinheit 8 kontaktiert. Somit ist die thermoelektrische Materialeinheit 8 zweiseitig am Leiterprofil 6 befestigt.

Die thermoelektrische Materialeinheit 8 wird beispielsweise aus den Materialgruppen der Skutterudite, Half-Heusler oder Silizide ausgewählt. Konkrete thermoelektrische Materialien können beispielsweise CoSb₃, Bi₂Te₃, PbTe oder Magnesium-/Mangan-Silizid sein. Die thermoelektrischen Materialeinheiten 8 können unter anderem über einen Drucksinterprozess, alternativ aber auch ein Spark-Plasma-Sintering, pulvermetallurgisch oder über diverse Kristallzuchtverfahren und Zonenschmelzverfahren hergestellt werden.

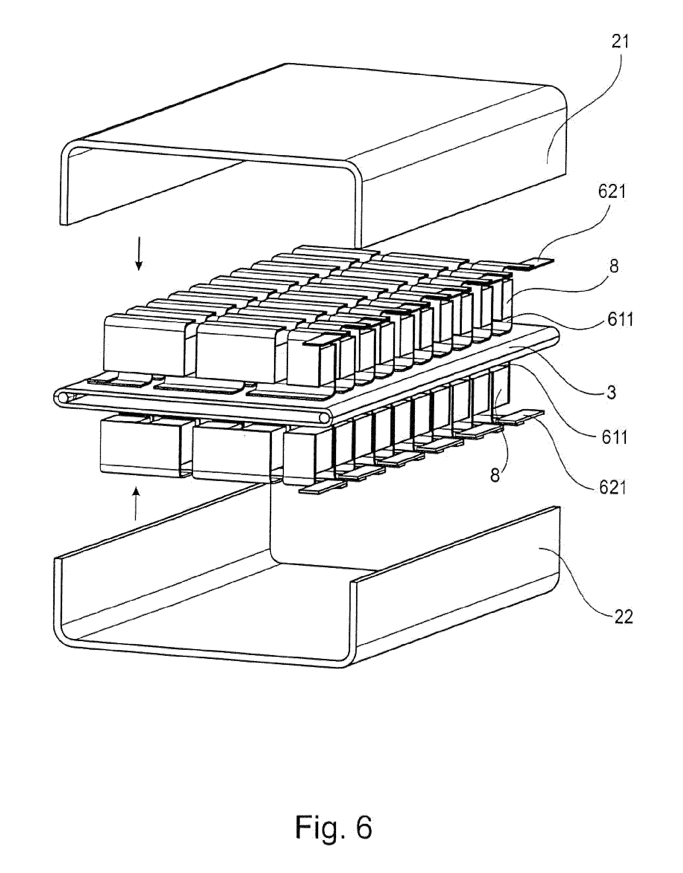

Nach der Montage des Leiterprofils 6 werden gemäß Fig. 6 die beiden Hälften 21, 22 des zweiten Rohres 2 über das Leiterprofil 6 geführt und verschlossen, so dass das erste Rohr 2 das Leiterprofil 6, die thermoelektrischen Materialeinheiten 8 sowie das zweite Rohr 3 vollständig umschließt. Dabei kontaktiert der jeweilige kurze Schenkel 612, 622 der Elemente 611, 621 des ersten und des zweiten Teiles 61, 62 des Leiterprofils 6 die zweite Verbindungsschicht 52, mit welcher die Rohre 2, 3 belegt sind.

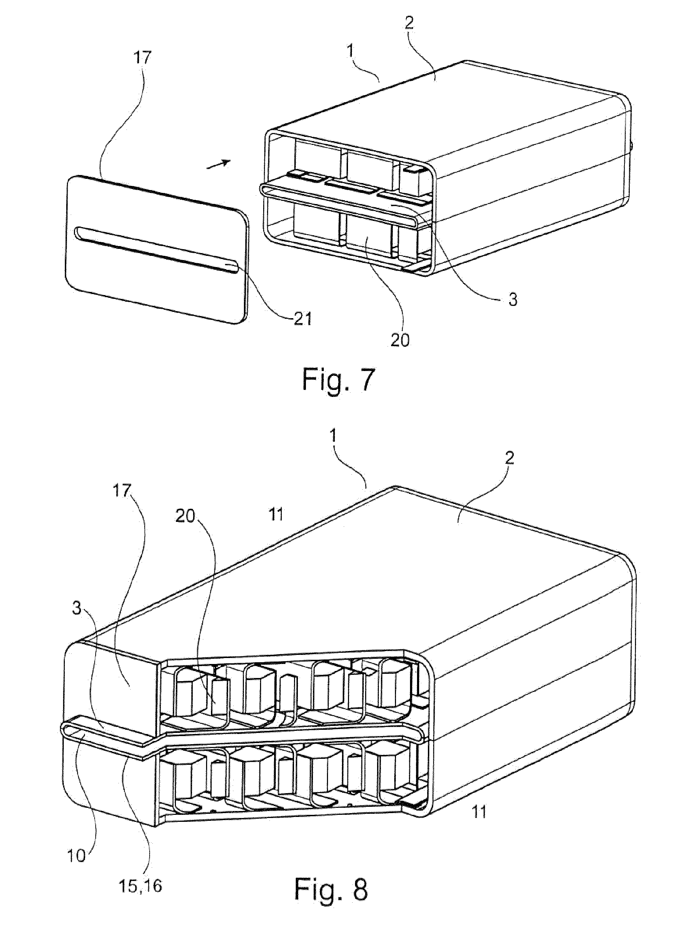

In Fig. 7 ist eine perspektivische Darstellung durch den, nach Fig. 1 aufgebauten und zusammengesetzten thermoelektrischen Wärmetauscher 1 dargestellt. Das zweite Rohr 3 ist dabei etwas länger als das erste Rohr 2 ausgebildet und greift in eine Öffnung 21 einer vertikalen Abdeckung 17 ein, welche nach Abschluss der Montage das erste Rohr 2 seitlich verschließt.

Der vollständig zusammengebaute thermoelektrische Wärmetauscher 1 ist in Fig. 8 dargestellt, bei welchem das zweite, seitlich offene Rohr 3 die

Abdeckung 17 überragt, wodurch das zweite Rohr 3 somit eine Austrittsöffnung 15 bzw. Eintrittsöffnung 16 für das zweite Fluid 10 besitzt. Ein solcher thermoelektrischer Wärmetauscher 1, der kompakt und robust ausgestaltet ist, kann mit den Böden eines weiteren Wärmetauschers verbunden werden.

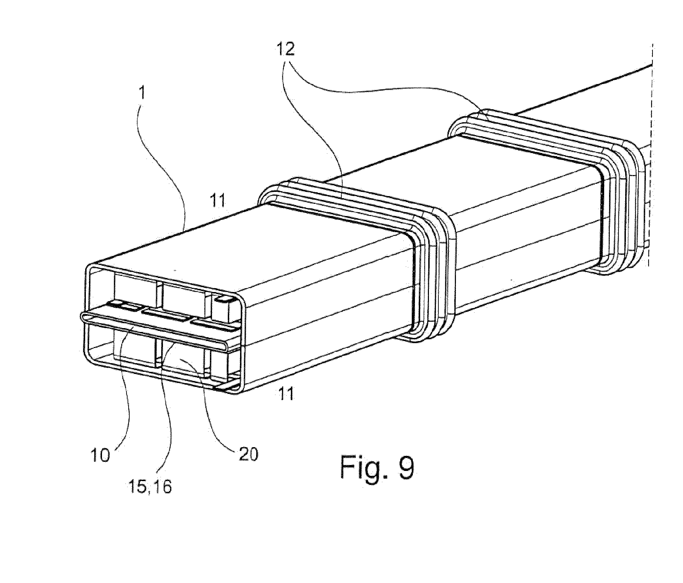

Fig. 9 zeigt ein zweites Ausführungsbeispiel eines thermoelektrischen Wärmetauschers 1, bei welchem die Rohre 2 und 3 in regelmäßigen Abständen durch Entkopplungselemente 12 unterbrochen sind. Diese Entkopplungselemente 12 können sowohl als Balg als auch als Feder ausgestaltet sein. Obwohl nicht weiter dargestellt, können die Entkopplungselemente 12 auch den Rohren 2, 3 vor- oder nachgeschaltet werden. Die Entkopplungselemente 12 haben die Aufgabe, thermische Ausdehnungsunterschiede zwischen der Kaltseite (Fluid 11, Fluid 10) und der Heißseite (Fluid 10, Fluid 11) auszugleichen bzw. auftretende Spannungen aufzunehmen.

Nicht weiter dargestellte elektrische Anschlüsse des erläuterten thermoelektrischen Wärmetauschers 1 können entweder am zweiten Rohr 3 als auch am ersten Rohr 2 vorgesehen sein, welche hierzu über entsprechende nicht weiter dargestellte Öffnungen verfügen, so dass entsprechende elektrische Leiterstränge mit den thermoelektrischen Materialeinheiten 8 über die erste und die zweite Verbindungsschicht 51, 52 und das Leiterprofil 6 kommunizieren können. Sind die elektrischen Leiterstränge am ersten Rohr 2 befestigt, so sind die zweite Verbindungsschicht 52 des ersten Rohres 2 und der zweite Teil 62 des Leiterprofils 6 sowie die an das Leiterprofil 6 grenzende erste Verbindungsschicht 51 elektrisch leitend und Wärme leitend ausgebildet, während die zweite Verbindungsschicht 52 des zweiten Rohres 3, die über den ersten Teil 61 des Leiterprofils 6 mit der ersten Verbindungsschicht 51 verbunden ist, nur Wärme leitend ausgebildet ist.

Eine weitere Möglichkeit besteht darin, die elektrische Anbindung über den Rohrspalt 14 an den jeweiligen axialen Enden der Rohre 2, 3 zugänglich zu machen, so dass zusätzliche Öffnungen in den Rohren 2, 3 nicht notwendig sind.

In den erläuterten Ausführungsbeispielen sind die verwendeten thermoelektrischen Materialien 8 bezogen zu den Rohrflächen 2, 3 um 90° gedreht an den Leiterprofilen 6 angebunden. Aufgrund der im Wesentlichen L-oder T-ähnlichen Gestaltung der Elemente 611, 621 des ersten Teiles 61 und des zweiten Teiles 62 des Leiterprofils 6 sind diese sowohl zu den Flächen der Rohre 2, 3 als auch zu den thermoelektrischen Materialeinheiten 8 orthogonal angeordnet. Dieser Aufbau entlastet die Elemente 611, 621 des ersten und des zweiten Teiles 61, 62 des Leiterprofils 6 bei thermomechanischen Beanspruchungen und sorgt dafür, dass sich thermisch bedingte Ausdehnungen der einzelnen thermoelektrischen Materialeinheiten 8 nicht aufsummieren können.

Das Leiterprofil 6 ist bevorzugter Weise ein umgeformtes Blech oder eine metallisierte Graphitfolie. Die einzelnen Elemente 611 und 621 des Leiterprofils 6 und die thermoelektrischen Materialeinheiten 8 sind miteinander verbunden, so dass sich je nach Ausführung und Zuordnung eine durchgängige Reihen- und/oder eine Parallelschaltung, bestehend aus den thermoelektrischen Materialeinheiten 8 und dem Leiterprofil 6, ergibt. Die Dehnfugen 18 in dem Leiterprofil 6 dienen der thermomechanischen Entkopplung.

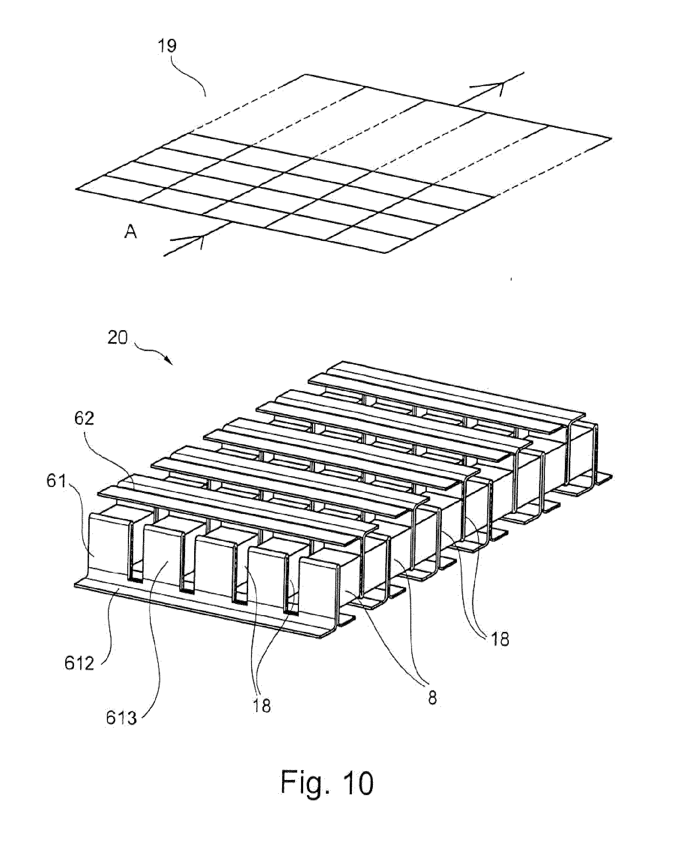

In den nachfolgenden Figuren 10 bis 12 sind verschiedene Ausführungsformen der Kopplung der thermoelektrischen Materialeinheiten 8 und des Leiterprofils 6, was im weiteren als thermoelektrische Vorrichtung 20 bezeichnet wird, sowie der dazugehörigen Stromflussverläufe aufgezeigt. Fig. 10 zeigt ein erstes Ausführungsbeispiel der thermoelektrischen Vorrichtung 20, welche als Parallel- und Reihenschaltung mit Dehnfugen 18 ausgebildet ist. Die einzelnen Reihen des Leiterprofils 6 weisen dabei T-ähnliche Elemente 611, 621 auf, welche aus einem Blech ausgestanzt sind, wobei die einzelnen T-ähnlichen Elemente 611, 621 über ihre kurzen Schenkel miteinander verbunden sind. Wird diese thermoelektrische Vorrichtung 20 in Richtung des Pfeils A bestromt, so wird der elektrische Strom über alle thermoelektrischen Materialeinheiten 8 geleitet, so dass ein gitterähnlicher Stromverlauf entsteht, wie er im elektrischen Ersatzschaltbild 19 dargestellt ist.

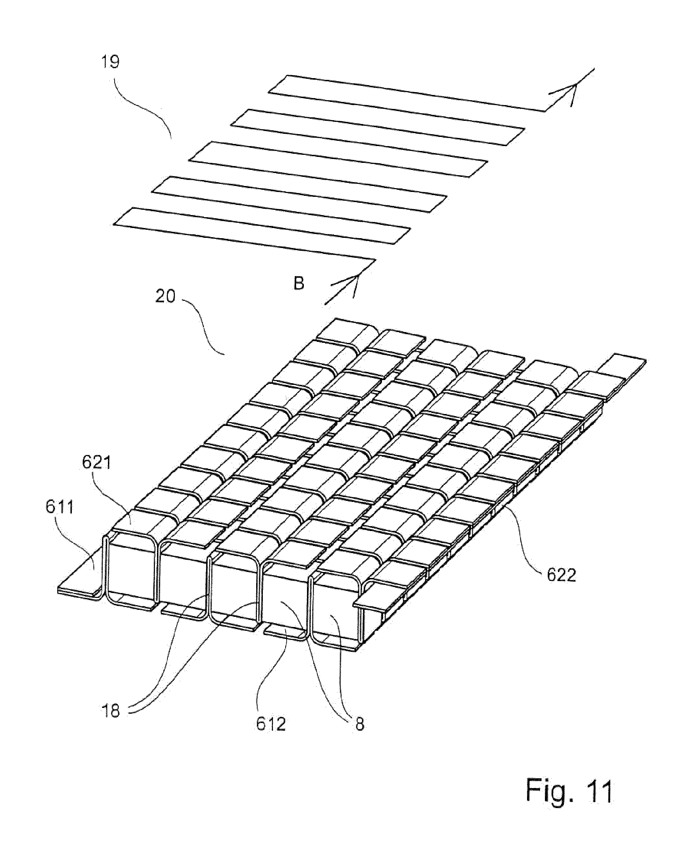

In Fig. 11 ist ein zweites Ausführungsbeispiel der thermoelektrischen Vorrichtung 20 aus Leiterprofil 6 und thermoelektrischen Materialeinheiten 8 als Reihenschaltung mit Dehnfugen 18 dargestellt. Die Dehnfugen 18 werden dabei innerhalb des langen Schenkels 613, 623 der T-ähnlichen, ersten und zweiten Elemente 611, 621 des ersten und des zweiten Teiles 61, 62 des Leiterprofils 6 gebildet. Die durch die einzelnen Elemente 611, 621 des Leiterprofils 6 gebildeten Reihen sind dabei in vertikaler Richtung in die Fig. 11 hinein gerichtet, während diese in Fig. 10 in horizontaler Richtung angeordnet sind. Bei dieser Reihenschaltung der Fig. 11 wird ein Strom an eine thermoelektrische Materialeinheit 8 angelegt, wobei der Stromverlauf in Richtung des Pfeiles B des elektrischen Ersatzschaltbildes 19 mäanderförmig verläuft.

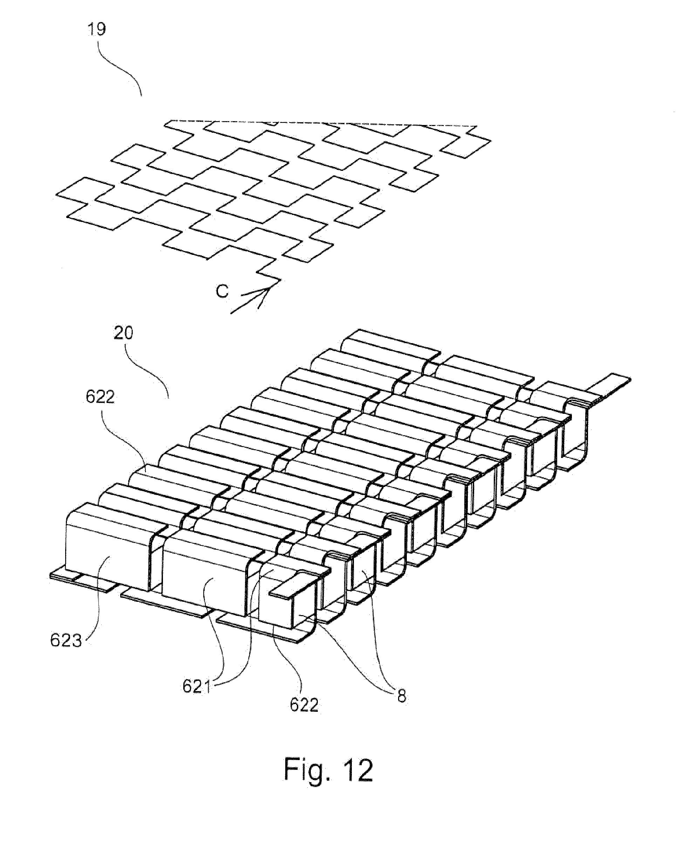

Eine weitere Reihenschaltung der thermoelektrischen Materialeinheiten 8 und des Leiterprofils 6 ist in Fig. 12 dargestellt, bei welcher die langen Schenkel 613, 623 des ersten und des zweiten Elementes 611, 621 des ersten und des zweiten Teiles 61, 62 des Leiterprofils 6 eine Reihe bilden, wodurch der durch diese Anordnung fließende Strom entsprechend der Pfeilrichtung C im Ersatzschaltbild 19 ebenfalls mäandriert.

Der erläuterte thermoelektrische Wärmetauscher 1 kann nicht nur in einem thermoelektrischen Generator eingesetzt werden, wodurch dieser konventionelle thermoelektrische Materialien ersetzt, sondern es besteht darüber hinaus die Möglichkeit, insbesondere bei Hybrid-Fahrzeugen oder batteriebetriebenen Elektrofahrzeugen herkömmliche kühlmittelgespeiste Heizer für die Beheizung der Fahrgastzelle durch diesen thermoelektrischen Wärmetauscher 1 zu ersetzen. Dieser thermoelektrische Wärmetauscher 1 wirkt dabei als elektrisch gespeister Heizer, welcher den Fahrgastraum aufwärmt. Mit einem solchen thermoelektrischen Heizer lassen sich im Gegensatz zu elektrischen Widerstandsheizern COP-Werte >1 verwirklichen. Unter dem COP-Wert wird dabei das Verhältnis von erzeugter Wärmeleistung zur eingesetzten Leistung verstanden.

Bei entsprechender Polung der thermoelektrischen Materialeinheiten 8 kann die Anlage auch zur Kühlung der Kabinenluft in einem Fahrzeug benutzt werden. Der vorgeschlagene thermoelektrische Wärmetauscher 1 ist so gestaltet, dass eine Einbindung in einen Rohrbündelwärmetauscher ohne Probleme möglich ist. Durch den Einsatz als Heizer entfällt bei der Wärmepumpe ein Kompressor, so dass auf bewegliche Teile vollständig verzichtet werden kann. Im Unterschied zu dem thermoelektrischen Generator werden bei einem thermoelektrischen Heizer bzw. Kühler die thermoelektrischen Elemente bestromt, wodurch Wärme von dem ersten Fluid in das andere Fluid gefördert wird. Durch einen solchen thermoelektrischen Wärmetauscher werden Wärmeverluste reduziert. Eine Thermoelektrik kann auf geeignete Weise in einen Wärmeübertrager integriert werden.

## Patentansprüche

1. Thermoelektrischer Wärmetauscher, umfassend zwei Rohre (2, 3), wobei ein erstes Rohr (2) ein zweites Rohr (3) umschließt, und eine thermoelektrische Materialeinheit (8), die zwischen dem ersten und dem zweiten Rohr (2, 3) angeordnet ist, wobei ein erstes Fluid (10) das erste Rohr (2) von außen umströmt, während ein zweites Fluid (11) durch das zweite Rohr (3) strömt, **dadurch gekennzeichnet, dass** die thermoelektrische Materialeinheit (8) an einem Leiterprofil (6) befestigt ist, welches das erste und das zweite Rohr (2, 3) über die thermoelektrische Materialeinheit (8) mechanisch miteinander verbindet.

2. Thermoelektrischer Wärmetauscher nach Anspruch 1, **dadurch gekennzeichnet, dass** das Leiterprofil (6) zweiteilig ausgebildet ist, wobei ein erster Teil (61) des Leiterprofils (6) am zweiten Rohr (3) positioniert ist, während ein zweiter Teil (62) des Leiterprofils (6) an dem ersten Rohr (2) befestigt ist und der erste und der zweite Teil (61, 62) des Leiterprofils (6) über die thermoelektrische Materialeinheit (8) miteinander verbunden sind.

3. Thermoelektrischer Wärmetauscher nach Anspruch 2, **dadurch gekennzeichnet, dass** das Leiterprofil (6) aus einer Mehrzahl von, in einen Rohrspalt (14) zwischen dem ersten und dem zweiten Rohr (2, 3) eingreifenden Elementen (611, 621) besteht, wobei die freien Enden der ersten Elemente (611) des ersten Teiles (61) des Leiterprofils (6) und die freien Enden der zweiten Elemente (621) des zweiten Teiles (62) des Leiterprofils (6) zueinander so ausgerichtet sind, dass wenigstens zwei, zueinander ragende, vorzugsweise L- oder T-ähnlich ausgebildete Elemente (611, 621) des ersten Teiles (61) und des zweiten Teiles (62) des Leiterprofils (6) die thermoelektrische Materialeinheit (8) tragen.

4. Thermoelektrischer Wärmetauscher nach Anspruch 3, **dadurch gekennzeichnet, dass** der Rohrspalt (14) zwischen dem ersten und dem zweiten Rohr (2, 3) mit einem Füllmaterial (9) ausgefüllt ist.

5. Thermoelektrischer Wärmetauscher nach Anspruch 3 oder 4, **dadurch gekennzeichnet, dass** die ersten und/oder zweiten Elemente (611, 621) des Leiterprofils (6) mindestens eine Dehnfuge (18) aufweisen.

6. Thermoelektrischer Wärmetauscher nach mindestens einem der vorhergehenden Ansprüche, **dadurch gekennzeichnet, dass** die, den ersten und/oder den zweiten Teil (61, 62) des Leiterprofils (6) tragenden Flächen des ersten und des zweiten Rohres (2, 3) eine elektrische Isolation (41, 42) aufweisen, wobei vorzugsweise zwischen der elektrischen Isolation (41, 42) und dem ersten und/oder zweiten Element (611, 621) des Leiterprofils (6) eine erste Verbindungsschicht (52) aufgetragen ist.

7. Thermoelektrischer Wärmetauscher nach mindestens einem der vorhergehenden Ansprüche, **dadurch gekennzeichnet, dass** auf die thermoelektrische Materialeinheit (8) eine Barriereschicht (7) aufgetragen ist, wobei vorzugsweise die Barriereschicht (7) und ein Element (611, 621) des ersten und/oder zweiten Teiles (61, 62) des Leiterprofils (6) über eine zweite Verbindungsschicht (51) miteinander verbunden sind.

8. Thermoelektrischer Wärmetauscher nach mindestens einem der vorhergehenden Ansprüche, **dadurch gekennzeichnet, dass** das erste und/oder zweite Rohr (2, 3) mindestens einen elektrischen Anschluss aufweisen, welcher mit der elektrisch leitenden ersten Verbindungsschicht (52) der, den ersten und/oder den zweiten Teil (61, 62) des Leiterprofils (6) tragenden Flächen des zweiten und des ersten Rohres (2, 3) kontaktiert ist.

9. Thermoelektrischer Wärmetauscher nach mindestens einem der vorhergehenden Ansprüche, **dadurch gekennzeichnet, dass** das erste und das zweite Rohr (2, 3) in mindestens einem vorgegebenen Abstand durch ein, vorzugsweise thermomechanisches, Entkopplungselement (12) unterbrochen ist.
